Europäisches Patentamt

European Patent Office

Office européen des brevets

(19)

(11) **EP 0 713 112 A1**

(12) **EUROPÄISCHE PATENTANMELDUNG**

(43) Veröffentlichungstag:
22.05.1996 Patentblatt 1996/21

(51) Int. Cl.⁶: **G02B 6/42**, G02B 6/43

(21) Anmeldenummer: 95112444.5

(22) Anmeldetag: 08.08.1995

(84) Benannte Vertragsstaaten:
**DE FR GB IT**

(30) Priorität: **17.11.1994 DE 4440976**

(71) Anmelder: **ANT Nachrichtentechnik GmbH**
**D-71522 Backnang (DE)**

(72) Erfinder:
• **Hauer, Heiner, Dipl.-Ing.**
**D-70734 Fellbach (DE)**
• **Kuke, Albrecht, Dr.-Ing.**
**D-71549 Auenwald (DE)**
• **Schwaderer, Bernhard, Dr.-Ing.**
**D-71554 Weissach im Tal (DE)**

(54) **Optische Sende- und Empfangseinrichtung mit einem oberflächenemittierenden Laser**

(57) Bei obigen Einrichtungen ist eine genaue Justierung sehr wichtig; die Einrichtungen sollten jedoch sehr kompakt sein. Es genügt nicht, die Silizium-Ätztechnik für die Genauigkeit auszunutzen.

Das optische Sendeelement (LD) befindet sich auf einem ersten Träger (T1), das optische Empfangselement (PD) und die Übertragungsfaser (Fa) auf einem dritten Träger. Dazwischen ist ein zweiter Träger (T2) vorgesehen, der für die Wellenlänge des vom Sendeelement (LD) ausgesendeten Lichts durchlässig ist. Die Träger sind durch anisotropes Ätzen strukturiert, um die Aufnahme der einzelnen Komponenten zu ermöglichen. Außerdem liegen die Träger flach aufeinander und können so justiert werden. Eine Monitordiode (MD) ist vorgesehen.

Anwendung der Anordnung in allen Übertragungssystemen mit Lichtwellenleitern.

Fig. 1

EP 0 713 112 A1

**Beschreibung**

Die Erfindung betrifft eine optische Sende- und Empfangseinrichtung mit einem oberflächenemittierenden Laser nach dem Oberbegriff des Patentanspruches 1.

Bei einer optischen Sende- und Empfangseinrichtung muß eine Übertragungsfaser an ein Sendeelement, üblicherweise eine Laserdiode, und an eine Photodiode als Empfangselement angekoppelt werden. In der Übertragungsfaser werden gleichzeitig die Sende- und Empfangssignale in entgegengesetzter Richtung übertragen. Die Sende- und Empfangssignale werden bei gleicher Wellenlänge über einen Strahlteiler und bei unterschiedlichen Wellenlängen über einen wellenlängenselektiven Verzweiger getrennt. Um möglichst geringe Koppelverluste zu erhalten, muß die Faser sowohl an die Laserdiode als auch an die Empfangsdiode optimal angekoppelt werden. Zur Ankopplung eines Lasers mit waagerecht liegendem Resonator und Lichtaustrittsfläche an der Stirnseite an eine Einmodenfaser muß wegen der unterschiedlichen Strahlcharakteristiken von beiden eine Strahltransformation durchgeführt werden. Hierzu wird üblicherweise eine Abbildung mit einer oder zwei Linsen verwendet. Das erforderliche Vergrößerungsverhältnis M liegt entsprechend dem Verhältnis der Modenfelddurchmesser von Laser und Faser bei etwa drei bis fünf. Bei einem neueren Laserdiodentyp, dem Vertical Cavity Surface Emittig Laser (VCSEL) ist der Resonatorraum und die Abstrahlrichtung senkrecht zur Chipoberfläche. Der Modenfelddurchmesser ist an den Modenfelddurchmesser einer Einmodenfaser angepaßt, um eine gute Kopplung zu erreichen. Das Vergrößerungsverhältnis ist in diesem Fall M = 1. Toleranzen in der Position des Lasers sind bei einem VCSEL von der gleichen Größenordnung, wie die Toleranzen einer Faser-Faser-Kopplung.

Oberflächenemittierende Laser (VCSEL) sind mehr noch als stirnflächenemittierende Laser sehr empfindlich gegenüber Rückreflexionen an externen Reflexionsflächen in den Laserresonator. Eine sehr kritische Reflexionsfläche wäre eine Faserstirnfläche, die unmittelbar vor dem Lichtaustrittsfenster des Lasers angebracht wäre, wie es zum Erreichen eines guten Koppelwirkungsgrades erforderlich wäre. Soll ein VCSEL in einem Transceiver-Modul eingesetzt werden, so muß zwischen der Übertragungsfaser und dem Laser ein Element zur Richtungstrennung eingebracht werden. Dieses Element läßt sich bei der Stirnflächenkopplung zwischen Laser und Faser aus Platzgründen nicht anbringen.

Aus der DE 39 14 835 C1 ist eine Anordnung zur Ankopplung eines Lichtwellenleiters an ein optisches Sende- oder Empfangselement bekannt.

Eine Justierung in der zur optischen Achse lateralen Ebene wird dadurch erreicht, daß Lichtwellenleiter und optisches Sende- oder Empfangselement auf verschiedenen Trägern fixiert sind, die mit ihren Trägeroberflächen verschiebbar aufeinander liegen und daß das Lichtbündel durch zweimalige Spiegelung an je einer auf einem Träger befindlichen Spiegelebene vom Lichtwellenleiter zum optisch aktiven Element oder umgekehrt gelangt. Durch Verschieben der Träger wird eine laterale Justierung durchgeführt. Der Träger, der das Sende- oder Empfangselement trägt, kann aus einem Substrat und einem darauf aufgebrachten Teil bestehen, das eine durchgehende Öffnung aufweist, durch die der Lichtstrahl tritt. Eine Anwendung der Anordnung in allen Übertragungssystemen mit Lichtwellenleitern, in Duplexern mit Lichtein- oder -auskopplung ist möglich. Für den Fall der Ankopplung an ein Sendeelement, insbesondere an einen kantenemittierenden Laser, kann auf dem Träger mit der Faser ein Empfangselement vorgesehen sein.

Ausgehend von diesem Stand der Technik ist es Aufgabe der Erfindung, eine optische Sende- und Empfangseinrichtung anzugeben, bei der der Justageaufwand verringert und die Montage vereinfacht ist.

Die Aufgabe wird durch eine Erfindung mit den Merkmalen der Patentansprüche 1 und 2 gelöst. Vorteilhafte Weiterbildungen sind in den Unteransprüchen angegeben.

Es wird eine Lösung vorgeschlagen, bei der eine justagefreie Montage aller Komponenten eines Transceiver-Moduls mit VCSEL möglich ist und die Ankopplung ohne schädliche Rückreflexionen auf den Laser erfolgt. Außerdem werden Vorschläge für eine reflexionsarme Ankopplung einer Monitordiode zur Regelung der Lichtleistung gemacht. Die hierbei erforderlichen Haltestrukturen können mikromechanisch im Großnutzen kostengünstig hergestellt werden.

Ausführungsbeispiele der Erfindung werden anhand der Zeichnungen beschrieben. Es zeigen:

Fig. 1 einen Schnitt durch eine erfindungsgemäße Anordnung mit Monitordiode auf dem Träger der Laserdiode;
Fig. 1a einen Schnitt durch eine erfindungsgemäße Anordnung mit Monitordiode auf dem Träger der Übertragungsfaser;
Fig. 2 Aufbau zur Justage der Anordnung;
Fig. 3 erfindungsgemäße Anordnung, wobei der dritte Träger mit seiner Stirnseite zum ersten Träger ausgerichtet ist und
Fig. 4 erfindungsgemäße Anordnung, deren dritter Träger gegenüber der Anordnung nach Fig. 1 vertikal und horizontal gespiegelt ist.

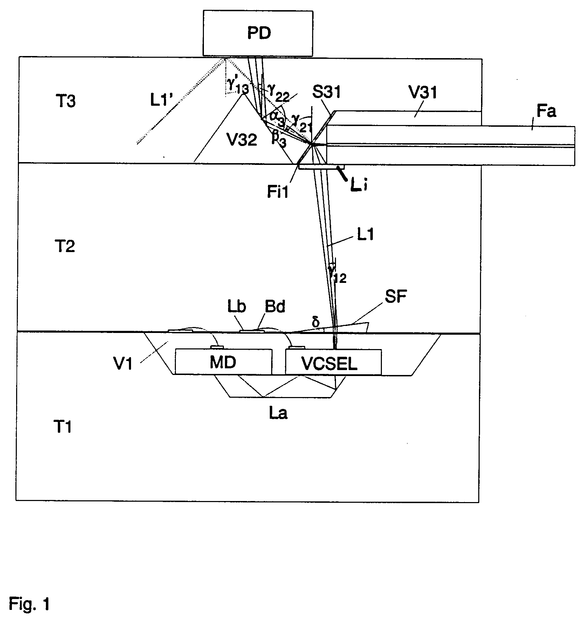

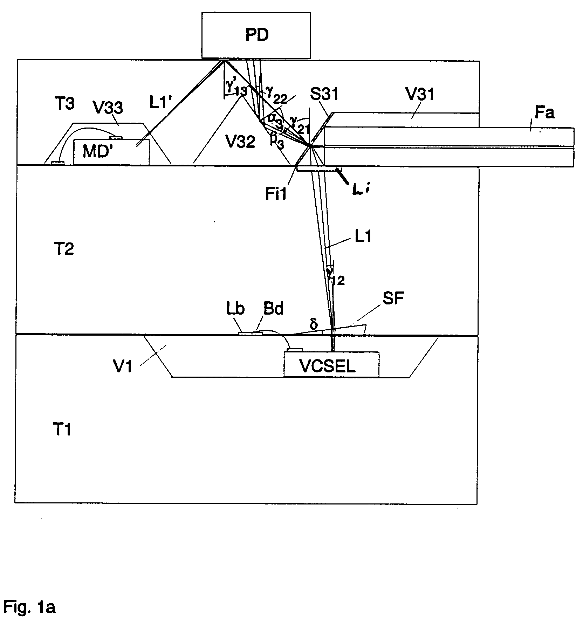

Ein erstes Ausführungsbeispiel der erfindungsgemäßen Lösung ist in Fig. 1 dargestellt. In einem ersten Träger T1, der aus einkristallinem Silizium besteht, wird durch anisotropes Ätzen eine Vertiefung V1 erzeugt, die einen ebenen Boden B1 besitzt, auf welchem eine senkrecht strahlende Laserdiode VCSEL montiert ist. Die Seitenflächen der Vertiefung haben infolge des anisotropen Ätzprozesses einen Neigungswinkel von $\alpha = \arctan(\sqrt{2}) = 54{,}7°$. Zur Erleich-

terung der Positionierung wird die Laserdiode bei der Montage an die Fußlinien von mindestens zwei rechtwinklig zueinander liegenden Seitenflächen angelegt.

Über dem Träger T1 ist ein zweiter Träger T2 angebracht, der für die Wellenlänge $\lambda_1$ des Laserlichtes transparent ist. Beispielsweise kann dieser zweite Träger ebenfalls aus Silizium bestehen. Es ist aber auch ein anderes transparentes Material möglich, das mikromechanisch strukturierbar ist. Auf der Unterseite des Trägers T2 wird in dem Bereich über der aktiven Fläche der VCSEL eine schräge Fläche SF strukturiert, deren Neigungswinkel $\delta$ gegenüber der Unterseite des Trägers T2 so groß ist, daß das senkrecht aus der VCSEL austretende Sendelichtbündel L1 an der geneigten Grenzfläche SF unter den Winkel $\gamma_{12}$ gebrochen wird. Auf der Oberseite des Trägers T2 ist eine Linse Li angebracht. Diese Linse kann vorteilhafterweise eine planar aufgebrachte Fresnellinse oder eine holographische Linse sein. Es sind aber auch andere Linsenarten möglich, wie zum Beispiel eine Kugellinse, die in einer mikromechanisch geformten Vertiefung sitzt, oder eine durch Trockenätzen erzeugte Linse. Die Linse Li wandelt das zunächst divergente Lichtbündel L1 in ein konvergentes Bündel um. Infolge der Lichtbrechung an der oberen Grenzfläche des Trägers T2 wird der Mittelstrahl des Lichtbündels unter dem Winkel

$$\gamma_{11} = \arcsin\left((n_2/n_o)^*\sin(\gamma_{12})\right)$$

gebrochen, wobei $n_o$ der Brechungsindex im Außenraum und $n_2$ der Brechungsindex im Träger T2 ist.

Über dem Träger T2 ist ein weiterer Träger T3 angebracht, der wie der Träger T1 ebenfalls aus einkristallinem Silizium besteht. In diesem Träger T3 sind zwei Vertiefungen V31 und V32 anisotrop geätzt. Die Vertiefung V31 ist eine V-Nut zur Aufnahme der Übertragungsfaser Fa. Die Breite dieser V-Nut ist dabei zweckmäßigerweise so groß, daß die unterste Mantellinie der Faser gerade in der Ebene der Unterseite von T3 zu liegen kommt. Die Stirnseite S3 der V-Nut ist mit einem wellenlängenselektiven Filter Fi1 beschichtet. Dieses Filter ist so ausgelegt, daß die Sendewellenlänge $\lambda_1$ reflektiert und die Empfangswellenlänge $\lambda_2$ durchgelassen wird. Das Sendelichtbündel L1 wird an der unter dem Winkel $\alpha$ geneigten Stirnfläche S31 dann in waagerechte Richtung reflektiert und in die Übertragungsfaser Fa eingekoppelt, wenn der Winkel $\gamma_{11}$ der folgenden Beziehung gehorcht:

$$\gamma_{11} = 2^*\alpha - 90° = 19,5°$$

Hieraus errechnet sich der Winkel $\gamma_{12}$ zu 5,5°, wenn für den Träger T2 der Brechungsindex von Silizium mit 3,4777 ($\lambda$ = 1550 nm) eingesetzt wird. Der Neigungswinkel $\delta$, der erforderlich ist, um an der Grenzfläche SF den Winkel $\gamma_{11} = 5,5°$ zu erzeugen, errechnet sich aus der transzendenten Gleichung

$$(n_2/n_o)^*\sin(\delta - \gamma_{11}) - \sin\delta = 0$$

Durch Iteration erhält man mit den oben angegebenen Werten für $n_2$, $n_o$ und $\gamma_{11}$ einen Neigungswinkel von $\delta = 8,71°$.

Statt durch Brechung an der geneigten Fläche kann der für die richtige Lichtführung erforderliche Winkel $\gamma_{12}$ auch durch andere Mittel erreicht werden. Beispielsweise kann auf der Oberfläche des VCSEL ein refraktives oder diffraktives Ablenkungselement wie zum Beispiel ein Fresnelelement oder ein Hologramm aufgebracht werden, das die Lichtrichtung um den Winkel $\gamma_{11}$ ablenkt, so daß durch Brechung an der Unterseite des Trägers T2 im Träger T2 der Winkel $\gamma_{12}$ erreicht wird. Eine weitere Möglichkeit besteht darin, den VCSEL-Chip selbst unter dem Winkel $\gamma_{11}$ geneigt zu montieren. Dies kann durch Schrägstellung des Bodens der Vertiefung V1 geschehen.

Da die Modenfelddurchmesser von VCSEL und Faser von annähernd gleicher Größe sind, muß die Linse Li so ausgelegt sein, daß eine 1:1-Abbildung mit M = 1 entsteht. Etwaige Unterschiede in den Modenfelddurchmessern können durch Anpassung des Abbildungsverhältnisses leicht kompensiert werden. Für ein Vergrößerungsverhältnis von M = 1 müssen auch die optischen Weglängen für die Gegenstands- und Bildweite gleich groß sein. Bei der Berechnung der optischen Weglängen muß jeweils der Brechungsindex des durchlaufenen Materials berücksichtigt werden. Die Gegenstandsweite kann durch die Wahl der Dicke des Trägers 2 an die Bildweite im Raum vor der Faser Fa angepaßt werden. Da die Koppeltoleranzen eines VCSEL in der Größe der Faser-Koppeltoleranzen sind, kann hier auf eine aktive Justage verzichtet werden. Die Koppeltoleranzen liegen in lateraler Richtung für Faser und VCSEL bei ca. 2 - 3 $\mu$m. In axialer Richtung liegen sie bei etwa 30 $\mu$m. Diese Toleranzen sind durch mikromechanisch strukturierte Silizium-Haltestrukturen einzuhalten, so daß eine justagefreie Montage möglich ist. Zur justagefreien Montage der drei Träger T1 - T3 aufeinander dienen mikromechanisch erzeugte Anschläge oder Vertiefungen Va, in die Justagekörper JK gelegt werden.

Das aus der Übertragungsfaser austretende Empfangslichtbündel L2 mit der Wellenlänge $\lambda_2$ durchdringt das Filter Fi1 und wird an der Grenze zum Silizium unter dem Winkel

$$\gamma_{21} = \alpha + \beta_3,$$

wobei $\beta_3$ der Brechungswinkel an der Stirnfläche S31 mit

$$\beta_3 = \arcsin((n_o/n_3)*\sin(90°-\alpha))$$

ist, gegen die Flächennormale der Substratoberfläche von T3 in das Silizium hineingebrochen. Dabei ist $n_o$ der Brechungsindex in der V-Nut V31 und $n_3 = 3{,}4777$ der Brechungsindex im Siliziumträger T3. Mit $n_o = 1$ für Luft erhält man $\beta_3 = 9{,}6°$ und $\gamma_{21} = 64{,}3°$. Das Lichtbündel L2 trifft auf die Seitenfläche S31 der Vertiefung V31 unter einem Einfallswinkel von

$$\alpha_3 = 180° -2*\alpha - \beta_3 = 61{,}0°.$$

Da dieser Winkel $\alpha_3$ größer als der Grenzwinkel der Totalreflexion beim Übergang Silizium/Luft von

$$\alpha_g = \arcsin(n_o/n_3) = 16{,}7°$$

ist, wird das Lichtbündel L2 unter dem Winkel

$$\gamma_{22} = \alpha_3 - \alpha = 6{,}3°$$

gegen die Flächennormale der Trägeroberfläche gebrochen. Der Winkel $\gamma_{22}$ ist kleiner als $\alpha_g$, so daß das Lichtbündel L2 auf der Oberfläche des Siliziumträgers T3 austreten kann. An der Austrittsstelle des Lichtbündels L2 wird die Empfangsdiode PD montiert. Die Position für die Photodiode ergibt sich aus den oben genannten Winkeln, dem Abstand der beiden Vertiefungen V31 und V32 voneinander und mit geringer Abhängigkeit von der Dicke des Trägers T3. Die Position der Lichtaustrittsfläche von L2 hängt dagegen nicht von der axialen Position der Faser Fa in der V-Nut V31 ab. Die Position der Lichtaustrittsfläche kann daher relativ zu den mikromechanisch erzeugten Vertiefungen V31 und V32 durch Marken oder Anschläge gekennzeichnet werden. Diese Marken oder Anschläge können durch photolithographische Technik sehr genau zu den Vertiefungen V31 und V32 ausgerichtet werden.

Zur Regelung der Lichtleistung des Sendelasers muß mit einer Monitordiode MD die Laserleitung gemessen werden. Auch die Monitordiode muß dabei reflexionsarm angekoppelt werden. Erfindungsgemäß wird unter der Laserdiode VCSEL eine schmale V-Nut Vm anisotrop geätzt. Eine Stirnseite Sm1 dieser V-Nut liegt dabei unterhalb der unteren Lichtaustrittsfläche der VCSEL und die andere Stirnfläche Sm2 unterhalb der neben der VCSEL angebrachten Monitordiode MD. Die Seitenwände der Monitor-V-Nut Vm sind verspiegelt, so daß das Monitorsignal nach mehreren Reflexionen in die Monitordiode gelangt.

Ein weiterer Vorteil der erfindungsgemäßen Lösung liegt darin, daß hierbei eine sehr hohe nahe Übersprechdämpfung erreicht werden kann. Eine hohe nahe Übersprechdämpfung ist erforderlich, damit das Sendesignal aus dem Laser nicht infolge ungenügender Richtungstrennung in die in der Nähe des Senders befindliche Empfangsdiode trifft und diese beim Empfang schwacher Nutzsignale stört. Filterschichten haben im allgemeinen nur eine begrenzte Fähigkeit zur Trennung verschiedener Wellenlängen. Daher wird ein kleiner Anteil des Sendelichtbündels L1 die Filterschicht S31 auch durchdringen. Der Strahlverlauf dieses Störlichtes ist als S1' gestrichelt dargestellt. Dieses Lichtbündel trifft aber unter dem Winkel

$$\gamma_{13}' = \alpha - \beta_3 = 45{,}2°$$

gegen die Flächennormale auf die Oberfläche des Trägers T3 auf. Dieser Winkel ist aber größer als der Grenzwinkel der Totalreflexion $\alpha_g = 16{,}7°$, so daß das direkte Störlicht vom Sender nicht in die Empfangsdiode gelangen kann.

In einer Variante des ersten Ausführungsbeispiels wird das Filter Fi1 so ausgelegt, daß noch ein geringer Teil des Sendelichtes das Filter durchdringt, während der größte Teil reflektiert wird. Dieses das Filter durchdringende Lichtbündel L1' wird erfindungsgemäß als Regelsignal benutzt. Die Monitordiode MD' wird dann nicht auf dem Träger T1 sondern in einer Aussparung V33 auf dem Träger T2 montiert. Dies ist in der Fig. 1 gestrichelt dargestellt.

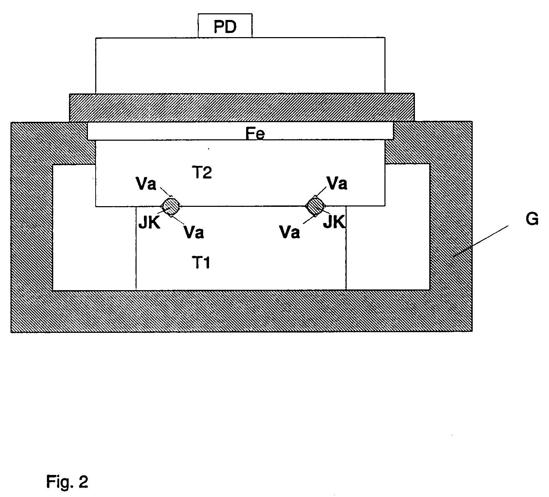

Auf eine aktive Justage der Faser zum Sendelichtbündel L1 kann wegen der im Vergleich zu einem stirnflächenemittierenden Laser größeren Modenfeld eines VCSEL verzichtet werden. Die erforderliche Genauigkeit im Bereich von 2 - 3 μm wird durch Justagekörper JK in Vertiefungen Va oder durch mikromechanisch erzeugte Anschläge in den einander gegenüberliegenden Oberflächen der Träger T1 bis T3 erreicht. Der Träger T2 kann dabei als lichtdurchlässiger hermetisch dichter Deckel des Gehäuses G dienen. Ebenso kann auch ein zusätzliches hermetisch dichtes Fenster Fe zwischen den Trägern T2 und T3 eingesetzt werden (Siehe Fig. 2).

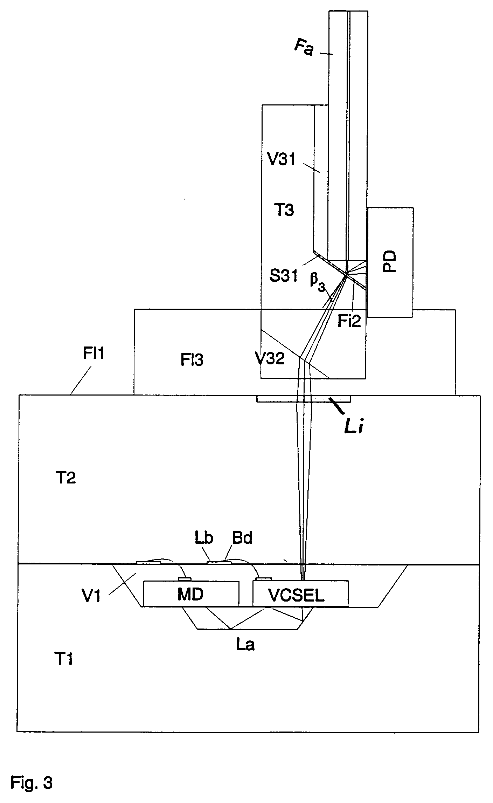

In einem zweiten Ausführungsbeispiel der erfindungsgemäßen Lösung wird der Träger T3 nicht mit seiner Unterseite sondern mit seiner Stirnseite zum Träger T2 ausgerichtet. Das zweite erfindungsgemäße Ausführungsbeispiel ist in der Fig. 3 dargestellt. Die Träger T1 und T2 sind wie im ersten Ausführungsbeispiel aufgebaut. Die Faser Fa wird auch hier wieder in einer V-Nut V31 in einem Träger T3 geführt und ist auch in dieser V-Nut axial justierbar. Die Stirnseite S31 ist ebenfalls mit einer wellenlängenselektiven Filterschicht Fi2 belegt. Im Unterschied zur Filterschicht F11 im ersten Ausführungsbeispiel ist die Filterschicht Fi2 für die Sendewellenlänge $\lambda_1$ durchlässig und für die Empfangswellenlänge $\lambda_2$

reflektierend. Das unter einem Winkel von $\gamma_{11}$ = 19,5° aus dem Träger T2 austretende Lichtbündel L1 trifft auf die Seitenwand S31 einer von der entgegengesetzten Seite in den Träger T3 anisotrop geätzten Vertiefung V32, deren der Seitenwand S32 gegenüberliegender Teil, beispielsweise durch Sägen, entfernt worden ist. Da die beiden Seitenflächen S32 und S31 parallel zueinander sind, wird das Sendelichtbündel S1 durch die zweimalige Brechung parallel versetzt und trifft dann in die Übertragungsfaser Fa. Im Unterschied zum ersten Ausführungsbeispiel muß hier nicht durch besondere Maßnahmen die Lichtstrahlrichtung im Träger T2 geneigt werden, sondern kann senkrecht bleiben. Der Träger T3 wird dann senkrecht zur Flächennormalen des Trägers T2 montiert. Die Empfangsdiode PD wird über der Stirnfläche S31 der Faser-V-Nut V31 montiert. Das aus der Faser austretende Empfangssignal hat in diesem Ausführungsbeispiel nur einen sehr kurzen Lichtweg bis zum Auftreffen auf die Empfangsdiode. Dadurch fächert es weniger auf, so daß eine kleinflächigere Photodiode eingesetzt werden kann.

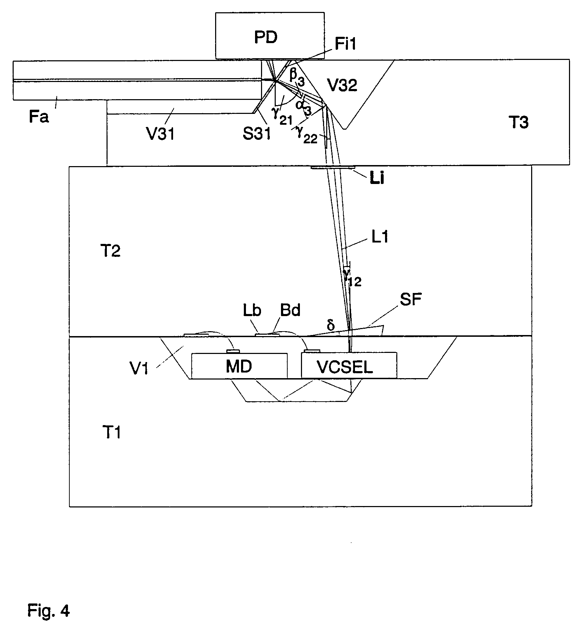

Ein drittes Ausführungsbeispiel der erfindungsgemäßen Lösung ist in der Fig. 4 dargestellt. Hier ist der Träger T3 ähnlich wie im ersten Ausführungsbeispiel aufgebaut, aber gegenüber dem ersten Ausführungsbeispiel vertikal und horizontal gespiegelt. Die Filterschicht Fi2 muß wie im Ausführungsbeispiel 2 für die Sendewellenlänge transparent und für die Empfangswellenlänge reflektierend sein. Die Photodiode PD für das Empfangssignal wird wie beim Ausführungsbeispiel 2 im Bereich über der Stirnfläche der V-Nut V31 montiert. Wie im Ausführungsbeispiel 2 hat man auch hier den Vorteil, daß der Weg zwischen Faserstirnfläche und Photodiode sehr kurz ist, was eine geringe Strahlaufweitung zur Folge hat und daher eine sehr kleinflächige Photodiode, die für hohe Frequenzen geeignet ist, erlaubt. Der Richtungswinkel $\gamma_{12}$ des Strahlbündels im Träger T2 ist für das Trägermaterial Silizium 5,5°. An diesen Richtungswinkel wird durch Maßnahmen, wie im ersten Ausführungsbeispiel beschrieben, der Richtungswinkel $\gamma_{21}$ des Strahlbündels im Träger T3 angepaßt. Der gegenüber dem ersten Ausführungsbeispiel hier längere Lichtweg im Träger T3 für das Sendelichtbündel muß durch eine entsprechende Dicke des Trägers T2 kompensiert werden.

Der Träger T2 mit der Linse Li wird im Großnutzen für viele Einzel-Module hergestellt und alle Linsen gemeinsam zu den Lasern in einem einzigen Justage- und Montageprozeß montiert. Hier ist eine passive Justage mittels Marken oder eine justagefreie Montage durch mikromechanisch strukturierte Anschläge möglich. Die Vertiefungen V2 im Träger T2 sind dabei so gestaltet, daß die optoelektronischen und elektronischen Bauelemente wie die Laserdiode LD, die Monitordiode MD oder hier nicht dargestellt elektronische Bausteine zur Ansteuerung des Lasers hermetisch dicht eingeschlossen sind. Nach der gemeinsamen Verbindung der Trägersubstrate T1 und T2 werden diese durch Sägen oder durch Brechen an mikromechanisch erzeugten Sollbruchlinien vereinzelt. Die Lage der Säge- bzw. Bruchlinien liegt dabei so, daß die Position der Vertiefungen V1 und V2 sowie der Linsen Li nicht berührt werden.

Die Monitordiode MD kann auch auf der Unterseite oder Oberseite der Träger T2 oder T3 montiert werden, wobei in dem jeweils benachbarten Träger entsprechende Aussparungen vorzusehen sind. Zur Ankopplung der Monitordiode kann auf dem Träger T2 eine weitere Linse Lim vorgesehen werden.

**Patentansprüche**

1. Optische Sende- und Empfangseinrichtung mit einem Sendeelement (LD), das auf einem ersten Träger (T1) fixiert ist, mit einem Empfangselement (PD) und einer Übertragungsfaser (Fa), die auf einem dritten Träger (T3) fixiert sind und mit einem zweiten Träger (T2), der sich zwischen dem ersten und dem dritten Träger (T1, T3) befindet, mit V-Nuten und Vertiefungen in den Trägern (T1, T2, T3), die durch anisotropes Ätzen hergestellt sind, mit mindestens einer Spiegelfläche am dritten Träger (T3), dadurch gekennzeichnet,
daß der dritte Träger (T3) für Licht mit der Wellenlänge des vom Sendeelement (LD) ausgesendeten Lichtes transparent ist, daß eine Monitordiode (MD) vorgesehen ist, die auf der Oberfläche des ersten Trägers (T1) in einer Aussparung des zweiten Trägers (T2) montiert ist,
daß das Sendeelement (LD) eine oberflächenemittierende Laserdiode ist und
daß die Anordnung zwischen der brechend wirksamen Oberfläche des zweiten Trägers (T2) und dem Sendeelement derart gewählt ist, daß der Strahl durch den zweiten Träger (T2) auf die Spiegelfläche (S31) und von dort auf die Übertragungsfaser (Fa) trifft.

2. Optische Sende- und Empfangseinrichtung mit einem Sendeelement (LD), das auf einem ersten Träger (T1) fixiert ist, mit einem Empfangselement (PD) und einer Übertragungsfaser (Fa), die auf einem dritten Träger (T3) fixiert sind und mit einem zweiten Träger (T2), der sich zwischen dem ersten und dem dritten Träger (T1, T3) befindet, mit V-Nuten und Vertiefungen in den Trägern (T1, T2, T3), die durch anisotropes Ätzen hergestellt sind, mit mindestens einer Spiegelfläche am dritten Träger (T3), dadurch gekennzeichnet, daß der dritte Träger (T3) für Licht mit der Wellenlänge des vom Sendeelement (LD) ausgesendeten Lichtes transparent ist, daß eine Monitordiode (MD) vorgesehen ist, die auf der Oberfläche des zweiten Trägers (T2) in einer Aussparung des dritten Trägers (T3) montiert ist, daß das Sendeelement (LD) eine oberflächenemittierende Laserdiode ist und daß die Anordnung zwischen der brechend wirksamen Oberfläche des zweiten Trägers (T2) und dem Sendeelement derart gewählt ist, daß der Strahl durch den zweiten Träger (T2) auf die Spiegelfläche (S31) und von dort auf die Übertragungsfaser (Fa) trifft.

3. Optische Sende- und Empfangseinrichtung nach Anspruch 1, dadurch gekennzeichnet, daß die optische Achse der Übertragungsfaser einen Winkel von 90° mit der Oberfläche der Träger (T1, T2) einschließt.

4. Optische Sende- und Empfangseinrichtung nach einem der Ansprüche 1 bis 3, dadurch gekennzeichnet, daß am zweiten Träger (T2) im Bereich des Eintritts des Strahls aus dem Sendeelement (LD) eine Abschrägung der Oberfläche des zweiten Trägers (T2) vorgesehen ist.

5. Optische Sende- und Empfangseinrichtung nach einem der Ansprüche 1 bis 3, dadurch gekennzeichnet, daß auf der emittierenden Oberfläche des Sendeelementes ein Hologramm oder eine Fresnellinse vorgesehen ist.

6. Optische Sende- und Empfangseinrichtung nach einem der Ansprüche 1 bis 3, dadurch gekennzeichnet, daß das Sendeelement (LD) gegen die Oberfläche der Träger geneigt am Träger (T1) angebracht ist.

Fig. 1

Fig. 1a

Fig. 2

Fig. 3

Fig. 4

| | Europäisches Patentamt | **EUROPÄISCHER RECHERCHENBERICHT** | Nummer der Anmeldung EP 95 11 2444 |
|---|---|---|---|

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A,D | DE-C-39 14 835 (ANT NACHRICHTENTECHNUK GMBH) 26.Juli 1990 <br> * das ganze Dokument * <br> --- | 1,2 | G02B6/42 <br> G02B6/43 |
| A | WO-A-93 14514 (BANGGAP TECHNOLOGY CORPORATION US) 22.Juli 1993 <br> * Seite 8, Zeile 18 - Zeile 35 * <br> * Seite 9, Zeile 1 - Zeile 35 * <br> * Seite 10, Zeile 1 - Zeile 32 * <br> * Seite 17, Zeile 3 - Zeile 12 * <br> * Abbildungen 1,8 * <br> --- | 1,2,5 | |
| A | WO-A-93 09456 (UNIV NORTH CAROLINA ;MCNC (US)) 13.Mai 1993 <br> * Seite 10, Zeile 21 - Zeile 36 * <br> * Seite 11 - Seite 12 * <br> * Seite 13, Zeile 1 - Zeile 18 * <br> * Seite 14, Zeile 4 - Zeile 28 * <br> * Abbildungen 2-7 * <br> --- | 1,2,5 | |
| A | US-A-4 169 001 (KAISER HAROLD D) 25.September 1979 <br> * das ganze Dokument * <br> --- | 1,2 | RECHERCHIERTE SACHGEBIETE (Int.Cl.6) <br><br> G02B |
| A | DE-A-43 13 493 (ANT NACHRICHTENTECH) 26.Mai 1994 <br> * das ganze Dokument * <br> ----- | 1,2 | |

Der vorliegende Recherchenbericht wurde für alle Patentansprüche erstellt

| Recherchenort | Abschlußdatum der Recherche | Prüfer |
|---|---|---|
| DEN HAAG | 15.März 1996 | Mathyssek, K |

EPO FORM 1503 03.82 (P04C03)